# EUROPEAN PATENT SPECIFICATION

(11) **EP 3 322 093 B1**
(45) Date of publication and mention of the grant of the patent: **16.09.2020**
(21) Application number: 16198867.0
(22) Date of filing: 15.11.2016
(51) Int. Cl.: H03K 17/16, H03K 17/687

(54) **GATE TRAJECTORY CONTROL FOR ZERO OVERSHOOT SWITCHING**
GATE-TRAJEKTORIESTEUERUNG FÜR NULLÜBERSCHWINGUNGSUMSCHALTUNG
COMMANDE DE TRAJECTOIRE DE GRILLE POUR COMMUTATION DE DÉPASSEMENT ZÉRO

(43) Date of publication of application: 16.05.2018
(73) Proprietor: Mitsubishi Electric R&D Centre Europe B.V., 1119 NS Schiphol Rijk (NL); Mitsubishi Electric Corporation, Tokyo 100-8310 (JP)
(72) Inventor: DEGRENNE, Nicolas, 35708 RENNES Cedex 7 (FR); MOLLOV, Stefan, 35708 RENNES Cedex 7 (FR); BRANDELERO, Julio, 35708 RENNES Cedex 7 (FR)
(74) Representative: Cabinet Le Guen Maillet

(56) References cited:
- EP-A1- 2 816 728

## Description

The present invention relates generally to a device and a method for controlling the switching of at least a first power semiconductor switch providing current to a load.

Today, the switching frequency of power converters is increasing. Wide-band gap devices like for example GaN and SiC provide faster switching capabilities than classical technologies.

Wide band gap power semiconductor devices are able to switch at a high speed like for example superior to 10V/ns. This reduces the switching losses, and thus allows the use of higher switching frequencies.

High switching speed may create voltage overshoots between drain and source of power semiconductor transistor for example due to the layout stray inductance increasing the switching losses and over stressing the transistor. Overshoot may also create conducted and radiated EMI and common mode perturbation.

The patent application EP 2816728 discloses an active gate drive circuit.

The present invention aims to allow a fast switching with a low voltage overshoot and reduced ringing at the end of the switching either during turn-on and turn-off using an active controlled feedback signal that is injected in the gate driver circuit.

To that end, the present invention concerns a device for controlling the switching from a conducting state to a non conducting state or from a non conducting state to a conducting state of at least one semiconductor power switch providing current to a load according to independent claim 1.

The present invention concerns also a method for controlling the switching from a conducting state to a non conducting state or from a non conducting state to a conducting state of at least one semiconductor power switch providing current to a load according to independent claim 9.

Thus, the switching is performed in two steps, to combine high speed and low overshoot. The activation of the second step (i.e. feedback) is performed based on the definition of a threshold.

According to a particular feature, the first threshold value is comprised between 70% to 100% of the value of the voltage of the power supplies the semiconductor power switch is connected to.

Thus, the turn-OFF is slowed down only at the end of the commutation, the commutation speed is maximized, and the switching losses minimized.

According to a particular feature, the first threshold value is equal to 80% of the value of the voltage of the power supplies the semiconductor power switch is connected to.

Thus, when the power supplies values vary, the threshold value is modified, and the switching trajectory is adjusted accordingly.

According to a particular feature, the second threshold value is comprised between 0% to 30% of the value of the voltage of the power supplies the semiconductor power switch is connected to.

Thus, the turn-ON is slowed down only at the end of the commutation, the commutation speed is maximized, and the switching losses minimized.

According to a particular feature, the second threshold value is equal to 20% of the value of the voltage of the power supplies the semiconductor power switch is connected to.

Thus, when the power supplies values vary, the threshold value is modified, and the switching trajectory is adjusted accordingly.

According to a particular feature, the device for controlling the switching from the conducting state to the non conducting state or from the non conducting state to the conducting state of two semiconductor power switches and in that the device further comprises:
- means for determining the current polarity in the load,
- means for selecting which switch among the two switches according to the determined current polarity, for enabling the control of the switching of the selected switch and for disabling the control of the switching of the switch which is not selected.

Thus, the invention can be used for example in an inverter application, where two switches are used in half-bridge configuration, and where the active switch changes periodically.

According to a particular feature, the semiconductor power switch is in a boost converter.

Thus, the invention can be applied in applications with only one active switch positionned on the low-side for a current flowing from an inductor acting as a load to the middle point connected to an anode of a diode the cathode of which is connected to a positive power supply and a drain of the semiconductor power switch.

According to a particular feature, the semiconductor power switch is in a buck converter.

Thus, the invention can be applied in applications with only one active switch positionned on the high-side for a current flowing the middle point connected to the cathode of a diode the anode of which is connected to a negative power supply and the source of the semiconductor power switch to an inductor acting as a load.

The characteristics of the invention will emerge more clearly from a reading of the following description of example embodiments, the said description being produced with reference to the accompanying drawings, among which :
Fig. 1a represents a first example of an architecture of a half bridge configuration in which the present invention may be implemented;
Fig. 1b represents an example of an architecture of a boost converter in which the present invention may be implemented;
Fig. 1c represents an example of an architecture of a buck converter in which the present invention may be implemented;
Fig. 2 represents a first example of an architecture of a gate trajectory control device according to the present invention;
Fig. 3 represents an electronic circuit of the gate trajectory control device according to the first example of gate trajectory control device;
Fig. 4 represents chronograms of signals provided according to the present invention;
Fig. 5 represents a second example of an architecture of a gate trajectory control device according to the present invention;
Fig. 6 represents an algorithm executed by the gate trajectory control device according to the second example of gate trajectory control device.

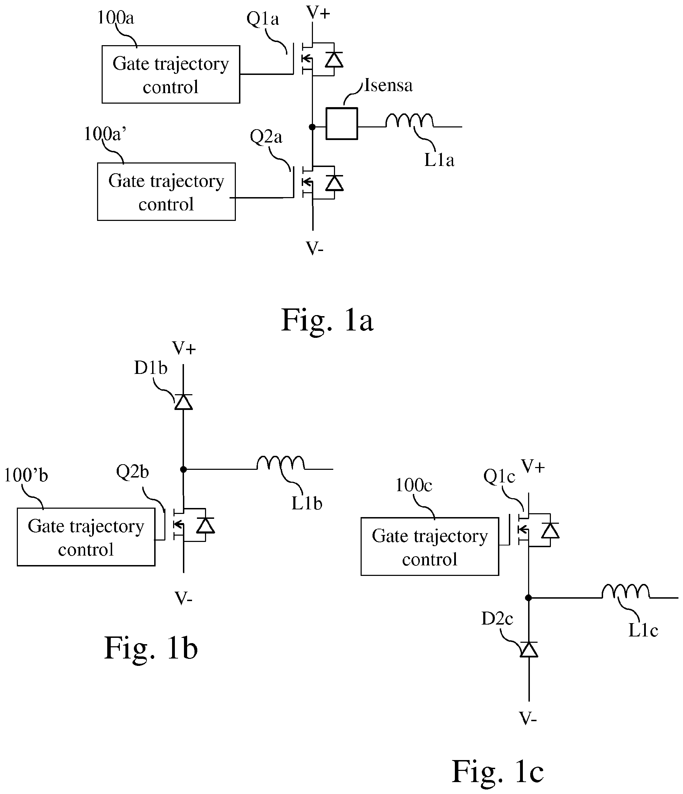

**Fig. 1a** represents a first example of an architecture of a half bridge configuration in which the present invention may be implemented.

In the example of Fig. 1a, a first gate trajectory control device 100a controls the switching of a power semiconductor switch Q1a and a second gate trajectory control device 100'a controls the switching of a power semiconductor switch Q2a.

A current polarity sensor Isensa senses the polarity of the current going through an inductor L1a.

The first gate trajectory control device 100a senses the drain to source voltage of the power semiconductor switch Q1a and the second gate trajectory control device 100'a senses the drain to source voltage of the power semiconductor switch Q2a. The drain of the power semiconductor switch Q1a is connected to a positive power supply V+. The source of the power semiconductor switch Q1a is connected to the drain of the power semiconductor switch Q2a and to the load L1a through the current polarity sensor Isensa. The source of the power semiconductor switch Q2a is connected to a negative power supply V-.

**Fig. 1b** represents an example of an architecture of a boost converter in which the present invention may be implemented.

In the example of Fig. 1b, a gate trajectory control device 100'b controls the switching of a power semiconductor switch Q2b that is connected to a diode D1b and a load L1b.

The gate trajectory control device 100'b senses the drain to source voltage of the power semiconductor switch Q2b.

The cathode of the diode D1b is connected to a positive power supply V+. The anode of the diode D1b is connected to the drain of the power semiconductor switch Q2b and to the load L1b. The source of the power semiconductor switch Q2b is connected to a negative power supply V-.

**Fig. 1c** represents an example of an architecture of a buck converter in which the present invention may be implemented.

In the example of Fig. 1c, a gate trajectory control device 100c controls the switching of a power semiconductor switch Q1c that is connected to a diode D2c and a load L1c.

The gate trajectory control device 100c senses the voltage of the drain of the power semiconductor switch Q1c.

The drain of the power semiconductor switch Q1c is connected to a positive power supply V+. The source of the power semiconductor switch Q1c is connected to the cathode of the diode D2c and to the load L1c. The anode of the diode D2c is connected to a negative power supply V-.

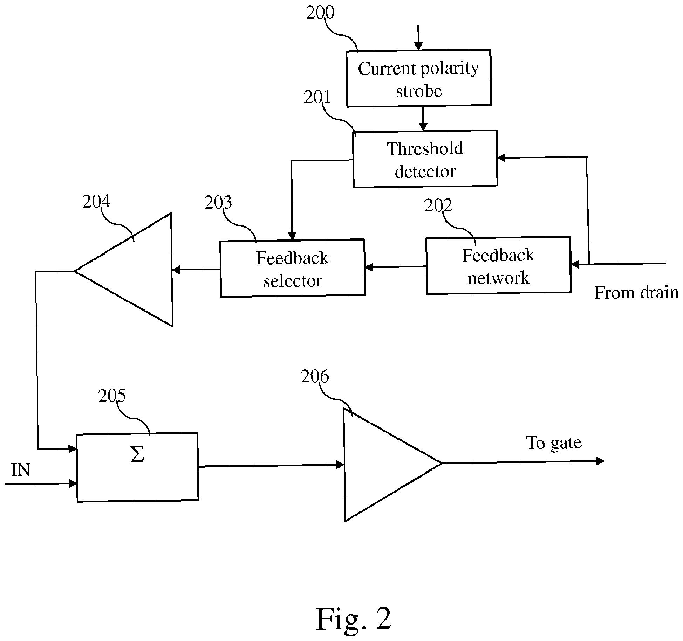

**Fig. 2** represents a first example of an architecture of a gate trajectory control device according to the present invention.

The gate trajectory control devices 100a, 100'a, 100'b and 100c are identical except for the fact that the gate trajectory control devices 100'b and 100c don't have a current polarity strobe module 200 as the polarity of the current is known and constant.

According to the invention, the drain to source transient voltage across a power semiconductor device is controlled in order to provide a fast switching, a low voltage overshoot and reduced switching oscillations.

The gate trajectory control device 100 covers the turn-off and turn-on of a power semiconductor device and dampens the oscillations by adding negative feedback to the gate commutation edges in proportion to the drain-source dv/dt.

The gate trajectory control device 100 performs the switching of the power MOSFET in two stages. Before a first threshold value TH1 is crossed, the control of the gate voltage is only performed by the normal input signal IN which is for example a Pulse width modulated signal with a low/disabled feedback. After the first threshold value is crossed, a feedback compensation is added to the normal gate control signal. Conversely, for the turn-on transition, a negative feedback would be activated only after the transistor voltage is lower than a second threshold voltage.

For example, the first threshold value is comprised between 70% to 100% of the total evolution of the voltage switching waveform, defined by the bus voltage V+ minus V- of typically several hundreds of volts. For example, the first threshold value is equal to 80% of the total evolution of the voltage switching waveform.

For example, the second threshold value is comprised between 0% to 30% of the total evolution of the voltage switching waveform, defined by the bus voltage voltage V+ minus V- of typically several hundreds of volts. For example, the second threshold value is equal to 20% of the total evolution of the voltage switching waveform.

The gate trajectory control device 100 may comprise a current polarity strobe 200 that determines, using the currents sensed by the current sensor Isensa, the polarity of the current, a threshold detector 201. The gate trajectory control device 100 comprises a feedback network 202, a feedback selector 203, an amplifier 204, a summation module 205 and a buffer 206.

The current polarity strobe 200 detects the sign of the switched current in the case of a classical half bridge topology as shown in Fig. 1a and determines the active switch during the switching time. For the case of simple power semiconductor switch Q1a or Q2a with anti-parallel diodes, the current polarity strobe ensures that the feedback is only active when the current does not naturally commutate through the anti-parallel diode.

The output of the current polarity strobe 200 is an enable signal that authorizes the feedback only in the active power semiconductor switch, the power semiconductor switch where the current does not naturally commutates through the anti-parallel diode, while the other power semiconductor switch performs a fast switching. For a positive current sign of *I* in the inductor L1a, i.e. current flowing from the middle point connected to the source of Q1a and the drain of Q2a to the inductor L1a, the active switch is Q1a. Conversely, for a negative current sign of *I* in the inductor L1a, i.e. current flowing from the inductor L1a to the middle point connected to the source of Q1a and the drain of Q2a, the active power semiconductor switch is Q2a.

For example, the current polarity strobe is a saturable current transformer loaded by a resistor R and a comparator with an hysteresis which detects the current direction in the middle point of the half bridge i.e. through the inductance L1a.

The feedback network 202 generates a signal that is proportional to the derivative of the drain to source voltage of the power semiconductor switch. The input of the feedback network 202 is the drain voltage of the power semiconductor switch and the output of the feedback network 202 is a signal that is connected to the feedback selector 203. The output of the feedback network 202 is the signal to control the feedback amplifier 204, when it is selected by the feedback selector 203.

The threshold detector 201 determines when the turn-on or turn-off feedback loop needs to be activated and deactivated. The input of the threshold detector 201 is the drain-source voltage and the current polarity strobe 200 output. The output of the threshold detector 201 generates signals that enable the feedback selector 203 to select the turn-on or turn-off feedback to be used.

The threshold detector 201 generates an image of the switched voltage, generates the first and second threshold values,one for selecting the turn-off feedback and one for selecting the turn-on feedback, compairs the drain to source voltage with the threshold values, and thus determines the instants when the turn-off and turn-on feedback loop is activated.

The threshold detector 201 generates a control signal to the feedback selector 204, the control signal activates the feedback selector 204 only if the current polarity strobe provides an enable signal.

The turn-off feedback control signal is activated when the power semiconductor switch voltage is higher than the first threshold voltage and the turn-on feedback control signal is activated when the power semiconductor switch voltage is lower than the second threshold voltage.

The feedback selector 203 activates or deactivates the turn-on or the turn-off feedback loops. The inputs of the feedback selector 203 are the feedback network 202 output signal and the control signals generated by the threshold detector 201. The output of the feedback selector 203 is the selected feedback signal allowing the turn-off or turn-on feedback. The turn-off feedback consists in allowing a positive output current in the feedback amplifier 204 and conversely the turn-on feedback consists in allowing a negative current in the output of the feedback amplifier 204.

The feedback amplifier 204 amplifies the signal from the feedback selector. The input of the feedback amplifier 204 is the signal to be amplified coming from the feedback network and the selectively fed by the feedback selector 203. The feedback amplifier is supplied by the gate driver power rails +Vcc and -Vdd that also supplies the buffer 206. The output signal of the feedback amplifier 204 is sent to the summation module 205.

The summation module 205 combines the input signal IN of switch Q1a, respectively Q2a with the feedback signal generated by the feedback amplifier 204.

The output of the summation module 205 is provided to a driver module 206 that amplifies the signal to be provided to the gate of semiconductor power switch Q1a, respectively Q2a.

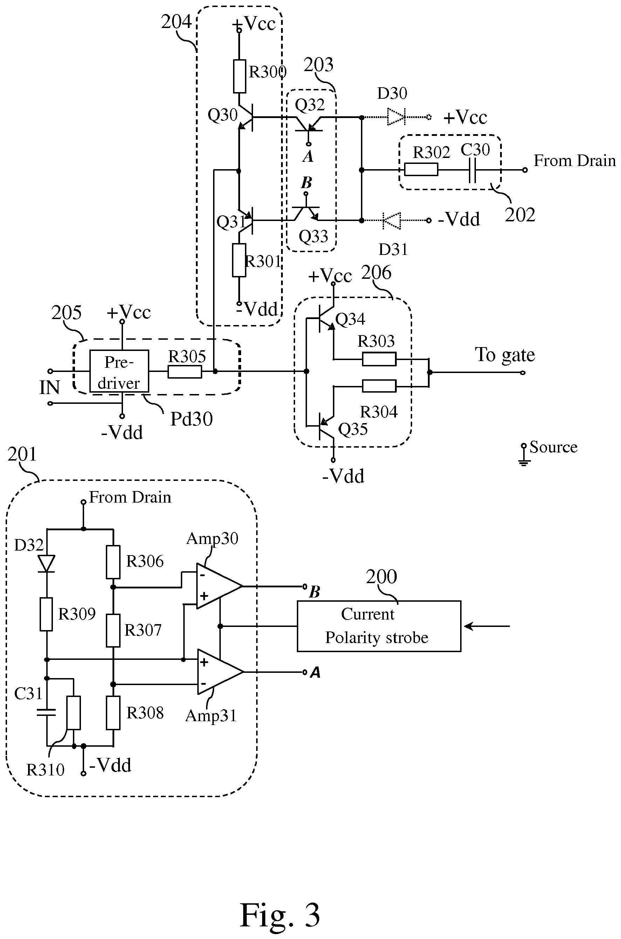

**Fig. 3** represents an electronic circuit of the gate trajectory control device according to the first example of gate trajectory control device.

The threshold detector generates the threshold values for the turn-off and turn-on of the power semiconductor switch Q1a or Q2a. Typically distinct circuits are used for the power semiconductor switches Q1a and Q2a so that no isolation mean is required. In the following, the power semiconductor switch switch Q1a is taken as an example, but similar circuits can be applied to the power semiconductor switches Q2a, Q2b and Q1c.

The drain of the power switch Q1a, respectively Q2a is connected to the anode of a diode D32 and to a first terminal of a resistor R306.

The cathode of the diode D32 is connected to a first terminal of a resistor R309.

A second terminal of the resistor R309 is connected to a positive input of a comparator Amp31, to a positive input of a comparator Amp30, to a first terminal of a capacitor C31 and to a first terminal of a resistor R310.

The voltage of the positive terminals of the comparators Amp30 and Amp31 are therefore set to a fraction of the bus voltage V+ minus V-.

A second terminal of the capacitor C31 is connected to a second terminal of the resistor R310, to a first terminal of a resistor R308 and to a negative power supply - Vdd. The voltage -Vdd is typically the source voltage of Q1a (respectively Q2a), or the source voltage of Q1a (respectively Q2a) minus few volts.

A second terminal of the resistor R306 is connected to a negative input of a comparator Amp30 and to a first terminal of a resistor R307.

A second terminal of the resistor R307 is connected to a negative input of the comparator Amp31 and to a second terminal of the resistor R308.

The output of the comparator Amp30 noted B is connected to a base of a PNP transistor Q32 and the output of the comparator Amp31 noted A is connected to a base of a NPN transistor Q33. It has to be noted here that other switches like for example MOSFET, HEMT transistors may be used instead of the PNP and NPN transsistors.

The comparators Amp30 and Amp31 are enabled by the output of the current polarity strobe module 200.

The feedback network 202 is composed of a capacitor C30 and a resistor R302.

A first terminal of the capacitor C30 is connected to the drain of the power switch Q1a, respectively Q2a.

A second terminal of the capacitor C30 is connected to a first terminal of a resistor R302. A second terminal of the resistor R302 is connected to the emetter of the transistor Q32 and to the emitter of the transistor Q33.

Optionally, the second terminal of the resistor R302 may be connected to the anode of a diode D30, the cathode of which is connected to a positive power supply +Vcc. +Vcc is typically the positive rail voltage of the gate driver.

Optionally, the second terminal of the resistor R302 may be connected to the cathode of a diode D31, the anode of which is connected to the negative power supply -Vdd. -Vdd is typically the positive rail voltage of the gate driver.

The feedback selector 203 is composed of the transistors Q32 and Q33.

The collector of the transistor Q32 is connected to the base of a NPN transistor Q30.

The collector of the transistor Q33 is connected to the base of a PNP transistor Q31.

The feedback amplifier 204 is composed of the transistors Q30, Q31 and of the resistors R300 and R301.

A first terminal of the resistor R300 is connected to the positive power supply +Vcc. A second terminal of the resistor R300 is connected to the collector of the transistor Q30.

The emitter of the transistor Q30 is connected to the emitter of the transistor Q31 and is the signal provided to the summation module 204.

The collector of the transistor Q31 is connected to a first terminal of the resistor R301, a second terminal of which is connected to the negative power supply -Vdd.

The summation module 205 is composed of a resistor R305.

As the impedance of the feedback amplifier 204 is lower than the impedance of the input signal IN that may be drived by a pre-driver module Pd30, the summation can be adjusted by varying the resistor R300 and R301 in proportion to R305.

The emitter of the transistor Q30 is connected to a first terminal of the resistor R305, the second terminal of which is connected to the output of the pre-driver module Pd30.

The first terminal of the resistor R305 is connected to the driver module 206 which is composed of two transistors Q34 and Q35 and two resistors R303 and R304.

The first terminal of the resistor R305 is connected to the base of the NPN transistor Q34 and to the base of the PNP transistor Q34.

The collector of the transistor Q34 is connected to the positive power supply +Vcc and the collector of the transistor Q35 is connected to the negative power supply -Vdd.

The emitter of the transistor Q34 is connected to a first terminal of the resistor R303.

The emitter of the transistor Q35 is connected to a first terminal of the resistor R305.

The second terminals of the resistors R303 and R304 are connected to the gate of the power semiconductor switch Q1a, Q2a respectively.

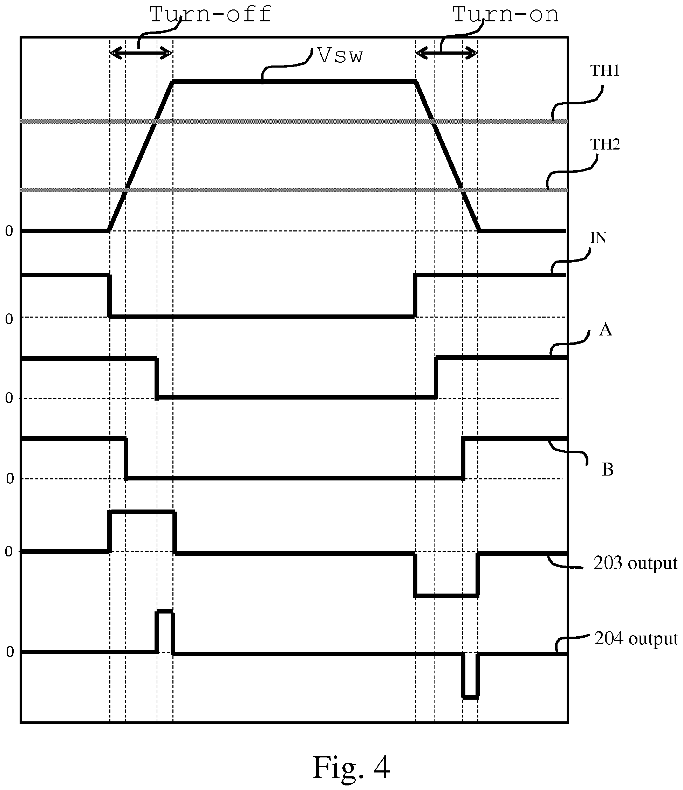

**Fig. 4** represents chronograms of signals provided according to the present invention.

The curves shown in Fig. 4 are described in an example wherein signals correspond to the conducting of the power semiconductor Q1a.

The curve noted Vsw is the drain-source voltage of the of the power semiconductor switch Q1a.

The line TH1 represents the first threshold value and the line TH2 represents the second threshold value.

When the input signal IN is at high level, the power semiconductor switch Q1a conducts.

When the drain-source voltage of the power semiconductor switch Q1a is higher than the first threshold TH1, the signal A at the output of the comparator Amp31 moves from high level to low level.

When the drain-source voltage of the power semiconductor switch Q1a is lower than the first threshold TH1, the signal A at the output of the comparator Amp31 moves from low level to high level.

When the drain-source voltage of the power semiconductor switch Q1a is higher than the second threshold TH2, the signal B at the output of the comparator Amp30 moves from high level to low level.

When the drain to source voltage of the power semiconductor switch Q1a is lower than the second threshold TH2, the signal B at the output of the comparator Amp30 moves from low level to high level.

The voltage at the output of the feedback selector 203 is positive when the power seminconductor switch Q1a is turning off and negative when the power seminconductor switch Q1a is turning on.

The amplitude of the voltage at the output of the feedback selector 203 is dependent on the voltage transient speed dV/dt of the drain to source voltage from conducting to non conducting over the switching time.

The amplitude of the voltage at the output of the feedback selector 203 is dependent on the voltage transient speed dV/dt of the drain to source voltage from non conducting to conducting over the switching time.

The output of the amplifier 204 covers the turn-off and turn-on of a power semiconductor device and dampens the oscillations by adding negative feedback to the gate commutation edges in proportion to the drain-source dv/dt when the drain-source voltage is above TH1 during turn-OFF and when the drain-source voltage is below TH2 during turn-ON.

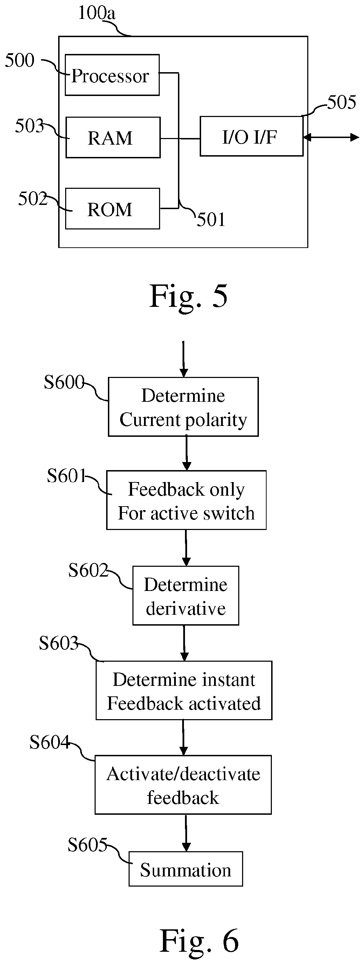

**Fig. 5** represents a second example of an architecture of a gate trajectory control device according to the present invention.

The gate trajectory control device 100 has, for example, an architecture based on components connected together by a bus 501 and a processor 500 controlled by a program as disclosed in Fig. 6.

The bus 501 links the processor 500 to a read only memory ROM 502, a random access memory RAM 503 and an input output I/O IF interface 505.

The memory 503 contains registers intended to receive variables and the instructions of the program related to the algorithm as disclosed in Fig. 6.

The processor 500 receives through the input output I/O IF 505 measurement of the drain to source voltage, the input signal IN and the output current sensor Isensa.

The read-only memory, or possibly a Flash memory 502 contains instructions of the program related to the algorithm as disclosed in Fig. 6, when the reference module 102 is powered on, to the random access memory 503.

The gate trajectory control device 100 may be implemented in software by execution of a set of instructions or program by a programmable computing machine, such as a PC (*Personal Computer*)*,* a DSP (*Digital Signal Processor*) or a microcontroller; or else implemented in hardware by a machine or a dedicated component, such as an FPGA (*Field-Programmable Gate Array*) or an ASIC (*Application-Specific Integrated Circuit*)*.*

In other words, the gate trajectory control device 100 includes circuitry, or a device including circuitry, causing the gate trajectory control device 100 to perform the program related to the algorithm as disclosed in Fig. 6.

**Fig. 6** represents an algorithm executed by the gate trajectory control device according to the second example of gate trajectory control device.

At step S600, the processor 500 obtains the current sensed by the current sensor Isensa and determines the polarity of the switched current in the case of a classical half bridge topology as shown in Fig. 1a and determines the active switch during the switching time.

At next step S601, the processor 500 enables the feedback only in the active power semiconductor switch. For a positive current sign of *I* in the inductor L1a, the active power semiconductor switch is Q1a. Conversely, for a negative current sign of *I* in the inductor L1a, the active power semiconductor switch is Q2a.

At next step S602, the processor 500 determines a value that is proportional to the derivative of the drain to source voltage of the power semiconductor switch.

At next step S602, the processor 500 selects the turn-on or turn-off feedback to be used.

At next step S603, the processor 500 generates an image of the switched voltage, generates the first and second threshold values, one for selecting the turn-off feedback and one for selecting the turn-on feedback, compairs the drain to source voltage with the threshold values, and determines the instants when the turn-off and turn-on feedback loop is activated.

At next step S604, the processor 500 activates the feedback only if the current polarity strobe provides an enable signal.

The turn-off feedback control signal is activated when the power semiconductor switch voltage is higher than the first threshold voltage and the turn-on feedback control signal is activated when the power semiconductor switch voltage is lower than the second threshold voltage.

The processor 500 activates or deactivates the turn-on or the turn-off feedback loops. The turn-off feedback consists in allowing a positive output current in the feedback loop and conversely the turn-on feedback consists in allowing a negative current in the output of the feedback loop.

At next step S605, the processor 500 combines the input signal IN of switch Q1a, respectively Q2a with the generated feedback signal.

The output of the summation is provided to a driver module hat amplifies the signal to be provided to the gate of semiconductor power switch Q1a, respectively Q2a.

Naturally, many modifications can be made to the embodiments of the invention described above without departing from the scope of the present invention.

## Claims

1. Device for controlling the switching from a conducting state to a non conducting state or from a non conducting state to a conducting state of at least one semiconductor power (Q1a, Q1b) switch providing current to a load, the device receiving an input signal that is intended to drive the semiconductor power switch, wherein the device comprises:
- means for determining a first and a second threshold (TH1, TH2) from a value of a power supply, the semiconductor power switch is connected to,
- means for sensing the drain to source voltage of the semiconductor power switch when the semiconductor power switch switches from the conducting state to the non conducting state,
- means for comparing, during the switching of the semiconductor power switch from the conducting state to the non conducting state, the drain to source voltage to the first threshold value,
- means for combining (205) the input signal with a voltage that is representative of the derivative of the drain to source voltage if the drain to source voltage is higher than the first threshold value, the means for combining the input signal and the voltage that is representative of the derivative of the drain to source voltage are adapted to drive the gate of the semiconductor power switch in order to limit the rate of change of the drain-source voltage,
- means for sensing the drain to source voltage of the semiconductor power switch when the semiconductor power switch switches from the non conducting state to the conducting state,
- means for comparing, during the switching of the semiconductor power switch from the non conducting state to the conducting state, the drain to source voltage to the second threshold value,
- means for combining the input signal with a voltage that is representative of the derivative of the drain to source voltage if the drain to source voltage is lower than the second threshold value, the means for combining the input signal and the voltage that is representative of the derivative of the drain to source voltage are adapted to drive the gate of the semiconductor power switch in order to limit the rate of change of the drain-source voltage.

2. Device according to claim 1, **characterized in that** the first threshold value is comprised between 70% to 100% of the value of the voltage of the power supplies the semiconductor power switch is connected to.

3. Device according to claim 2, **characterized in that** the first threshold value is equal to 80% of the value of the voltage of the power supplies the semiconductor power switch is connected to.

4. Device according to any of the claims 1 to 3 **characterized in that** the second threshold value is comprised between 0% to 30% of the value of the voltage of the power supplies the semiconductor power switch is connected to.

5. Device according to claim 4, **characterized in that** the second threshold value is equal to 20% of the value of the voltage of the power supplies the semiconductor power switch is connected to.

6. Device according to any of the claim 1 to 5, **characterized in that** the device for controlling the switching from the conducting state to the non conducting state or from the non conducting state to the conducting state of two semiconductor power switches and **in that** the device further comprises:
- means for determining the current polarity in the load,
- means for selecting a switch among the two switches according to the determined current polarity, for enabling the control of the switching of the selected switch and for disabling the control of the switching of the switch which is not selected.

7. Device according to any of the claim 1 to 5, **characterized in that** the semiconductor power switch is in a boost converter.

8. Device according to any of the claim 1 to 5, **characterized in that** the semiconductor power switch is in a buck converter.

9. Method for controlling the switching from a conducting state to a non conducting state or from a non conducting state to a conducting state of at least one semiconductor power switch providing current to a load, the device receiving an input signal that drives the semiconductor power switch, the method comprising the steps of:
- determining a first and a second threshold from a value of a power supply, the semiconductor power switch is connected to,
- sensing the drain to source voltage of the semiconductor power switch when the semiconductor power switch switches from the conducting state to the non conducting state,
- comparing, during the switching of the semiconductor power switch from the conducting state to the non conducting state, the drain to source voltage to the first threshold value,
- combining the input signal with a voltage that is representative of the derivative of the drain to source voltage if the drain to source voltage is higher than the first threshold value, and driving the gate of the semiconductor power switch in order to limit the rate of change of the drain-source voltage,
- sensing the drain to source voltage of the semiconductor power switch when the semiconductor power switch switches from the non conducting state to the conducting state,
- comparing, during the switching of the semiconductor power switch from the non conducting state to the conducting state, the drain to source voltage to the second threshold value,
- combining the input signal with a voltage that is representative of the derivative of the drain to source voltage if the drain to source voltage is lower than the second threshold value, and driving the gate of the semiconductor power switch in order to limit the rate of change of the drain-source voltage.

## Patentansprüche

1. Vorrichtung zum Steuern des Schaltens von einem leitenden zu einem nichtleitenden Zustand oder von einem nichtleitenden zu einem leitenden Zustand von wenigstens einem Halbleiterleistungsschalter (Q1a, Q1b), der Strom zu einer Last liefert, wobei die Vorrichtung ein Eingangssignal empfängt, das den Halbleiterleistungsschalter antreiben soll, wobei die Vorrichtung folgendes umfasst:
- Mittel zum Bestimmen einer ersten und einer zweiten Schwelle (TH1, TH2) aus einem Wert einer Leistungsversorgung, an die der Halbleiterleistungsschalter angeschlossen ist,
- Mittel zum Erfassen der Drain-Source-Spannung des Halbleiterleistungsschalter, wenn der Halbleiterleistungsschalter vom leitenden Zustand zum nichtleitenden Zustand schaltet,
- Mittel zum Vergleichen, während des Schaltens des Halbleiterleistungsschalters vom leitenden Zustand zum nichtleitenden Zustand, der Drain-Source-Spannung mit dem ersten Schwellenwert,
- Mittel zum Kombinieren (205) des Eingangssignals mit einer Spannung, die die Ableitung der Drain-Source-Spannung darstellt, wenn die Drain-Source-Spannung höher als der erste Schwellenwert ist, wobei die Mittel zum Kombinieren des Eingangssignals und der Spannung, die die Ableitung der Drain-Source-Spannung darstellt, dazu geeignet sind, das Gate des Halbleiterleistungsschalters anzutreiben, um die Änderungsrate der Drain-Source-Spannung zu begrenzen,
- Mittel zum Erfassen der Drain-Source-Spannung des Halbleiterleistungsschalter, wenn der Halbleiterleistungsschalter vom nichtleitenden Zustand zum leitenden Zustand schaltet,
- Mittel zum Vergleichen, während des Schaltens des Halbleiterleistungsschalters vom nichtleitenden Zustand zum leitenden Zustand, der Drain-Source-Spannung mit dem zweiten Schwellenwert,
- Mittel zum Kombinieren des Eingangssignals mit einer Spannung, die die Ableitung der Drain-Source-Spannung darstellt, wenn die Drain-Source-Spannung niedriger als der zweite Schwellenwert ist, wobei die Mittel zum Kombinieren des Eingangssignals und der Spannung, die die Ableitung der Drain-Source-Spannung darstellt, dazu geeignet sind, das Gate des Halbleiterleistungsschalters anzutreiben, um die Änderungsrate der Drain-Source-Spannung zu begrenzen.

2. Vorrichtung nach Anspruch 1, **dadurch gekennzeichnet, dass** der erste Schwellenwert zwischen 70% und 100% des Werts der Spannung der Leistungsversorgungen umfasst ist, an die der Halbleiterleistungsschalter angeschlossen ist.

3. Vorrichtung nach Anspruch 2, **dadurch gekennzeichnet, dass** der erste Schwellenwert gleich 80% des Werts der Spannung der Leistungsversorgungen ist, an die der Halbleiterleistungsschalter angeschlossen ist.

4. Vorrichtung nach einem der Ansprüche 1 bis 3, **dadurch gekennzeichnet, dass** der zweite Schwellenwert zwischen 0% und 30% des Werts der Spannung der Leistungsversorgungen umfasst ist, an die der Halbleiterleistungsschalter angeschlossen ist.

5. Vorrichtung nach Anspruch 4, **dadurch gekennzeichnet, dass** der zweite Schwellenwert gleich 20% des Werts der Spannung der Leistungsversorgungen ist, an die der Halbleiterleistungsschalter angeschlossen ist.

6. Vorrichtung nach einem der Ansprüche 1 bis 5, **dadurch gekennzeichnet, dass** die Vorrichtung zum Steuern des Schaltens vom leitenden Zustand zum nichtleitenden Zustand oder vom nichtleitenden Zustand zum leitenden Zustand für zwei Halbleiterleistungsschalter dient und dass die Vorrichtung weiterhin folgendes umfasst:
- Mittel zum Bestimmen der Strompolarität in der Last,
- Mittel zum Auswählen eines Schalters unter den zwei Schaltern gemäß der bestimmten Strompolarität, zum Freigeben der Steuerung des Schaltens des ausgewählten Schalters und zum Sperren der Steuerung des Schalters, der nicht ausgewählt ist.

7. Vorrichtung nach einem der Ansprüche 1 bis 5, **dadurch gekennzeichnet, dass** der Halbleiterleistungsschalter ein Aufwärtswandler ist.

8. Vorrichtung nach einem der Ansprüche 1 bis 5, **dadurch gekennzeichnet, dass** Halbleiterleistungsschalter ein Abwärtswandler ist.

9. Verfahren zum Steuern des Schaltens von einem leitenden zu einem nichtleitenden Zustand oder von einem nichtleitenden zu einem leitenden Zustand von wenigstens einem Halbleiterleistungsschalter, der Strom zu einer Last liefert, wobei die Vorrichtung ein Eingangssignal empfängt, das den Halbleiterleistungsschalter antreibt, wobei das Verfahren die folgenden Schritte umfasst:
- Bestimmen einer ersten und einer zweiten Schwelle aus einem Wert einer Leistungsversorgung, an die der Halbleiterleistungsschalter angeschlossen ist,
- Erfassen der Drain-Source-Spannung des Halbleiterleistungsschalter, wenn der Halbleiterleistungsschalter vom leitenden Zustand zum nichtleitenden Zustand schaltet,
- Vergleichen, während des Schaltens des Halbleiterleistungsschalters vom leitenden Zustand zum nichtleitenden Zustand, der Drain-Source-Spannung mit dem ersten Schwellenwert,
- Kombinieren des Eingangssignals mit einer Spannung, die die Ableitung der Drain-Source-Spannung darstellt, wenn die Drain-Source-Spannung höher als der erste Schwellenwert ist, und Antreiben des Gates des Halbleiterleistungsschalters, um die Änderungsrate der Drain-Source-Spannung zu begrenzen,
- Erfassen der Drain-Source-Spannung des Halbleiterleistungsschalter, wenn der Halbleiterleistungsschalter vom nichtleitenden Zustand zum leitenden Zustand schaltet,
- Vergleichen, während des Schaltens des Halbleiterleistungsschalters vom nichtleitenden Zustand zum leitenden Zustand, der Drain-Source-Spannung mit dem zweiten Schwellenwert,
- Kombinieren des Eingangssignals mit einer Spannung, die die Ableitung der Drain-Source-Spannung darstellt, wenn die Drain-Source-Spannung niedriger als der zweite Schwellenwert ist, und Antreiben des Gates des Halbleiterleistungsschalters, um die Änderungsrate der Drain-Source-Spannung zu begrenzen.

## Revendications

1. Dispositif de contrôle de la commutation d'un état de conduction à un état de non conduction ou d'un état de non conduction à un état de conduction d'au moins un commutateur de puissance à semi-conducteur (Qla, Qlb) fournissant du courant à une charge, le dispositif recevant un signal d'entrée qui est destiné à piloter le commutateur de puissance à semi-conducteur, dans lequel le dispositif comporte :
- des moyens de détermination d'un premier et d'un deuxième seuils (TH1, TH2) à partir d'une valeur d'une alimentation à laquelle le commutateur de puissance à semi-conducteur est connecté,
- des moyens de détection de la tension drain-source du commutateur de puissance à semi-conducteur lorsque le commutateur de puissance à semi-conducteur passe de l'état de conduction à l'état de non conduction,
- des moyens de comparaison, lors de la commutation du commutateur de puissance à semi-conducteur de l'état de conduction à l'état de non conduction, de la tension drain-source à la première valeur de seuil,
- des moyens de combinaison (205) du signal d'entrée avec une tension représentative de la dérivée de la tension drain-source si la tension drain-source est supérieure à la première valeur de seuil, les moyens de combinaison du signal d'entrée avec la tension qui est représentatif de la dérivée de la tension drain-source sont adaptés pour piloter la grille du commutateur de puissance à semi-conducteur afin de limiter la vitesse de variation de la tension drain-source,
- des moyens de détection de la tension drain-source du commutateur de puissance à semi-conducteur lorsque le commutateur de puissance à semi-conducteur passe de l'état de non conduction à l'état de conduction,
- des moyens de comparaison, lors de la commutation du commutateur de puissance à semi-conducteur de l'état de non conduction à l'état de conduction, de la tension drain-source à la deuxième valeur de seuil,
- des moyens de combinaison du signal d'entrée avec une tension représentative de la dérivée de la tension drain-source si la tension drain-source est inférieure à la deuxième valeur de seuil, les moyens de combinaison du signal d'entrée avec la tension représentative de la dérivée de la tension drain-source sont adaptés pour piloter la grille du commutateur de puissance à semi-conducteur afin de limiter la vitesse de variation de la tension drain-source.

2. Dispositif selon la revendication 1, **caractérisé en ce que** la première valeur de seuil est comprise entre 70% à 100% de la valeur de la tension des alimentations auxquelles est connecté le commutateur de puissance à semi-conducteur.

3. Dispositif selon la revendication 2, **caractérisé en ce que** la première valeur de seuil est égale à 80% de la valeur de la tension des alimentations auxquelles est connecté le commutateur de puissance à semi-conducteur.

4. Dispositif selon l'une quelconque des revendications 1 à 3, **caractérisé en ce que** la deuxième valeur de seuil est comprise entre 0% à 30% de la valeur de la tension des alimentations auxquelles est connecté le commutateur de puissance à semi-conducteur.

5. Dispositif selon la revendication 4, **caractérisé en ce que** la deuxième valeur de seuil est égale à 20% de la valeur de la tension des alimentations auxquelles est connecté le commutateur de puissance à semi-conducteur.

6. Dispositif selon l'une quelconque des revendications 1 à 5, **caractérisé en ce que** le dispositif de contrôle de la commutation de l'état de conduction à l'état de non conduction ou de l'état de non conduction à l'état de conduction contrôle deux commutateurs de puissance à semi-conducteur et **en ce que** le le dispositif comporte en outre :
- des moyens de détermination de la polarité du courant dans la charge,
- des moyens de sélection d'un commutateur parmi les deux commutateurs selon la polarité du courant déterminée, pour permettre la commande de la commutation du commutateur sélectionné et pour désactiver la commande de la commutation du commutateur qui n'est pas sélectionné.

7. Dispositif selon l'une quelconque des revendications 1 à 5, **caractérisé en ce que** le commutateur de puissance à semi-conducteur est dans un convertisseur élévateur.

8. Dispositif selon l'une quelconque des revendications 1 à 5, **caractérisé en ce que** le commutateur de puissance à semi-conducteur est dans un convertisseur abaisseur.

9. Procédé de contrôle de la commutation d'un état de conduction à un état de non conduction ou d'un état de non conduction à un état de conduction d'au moins un commutateur de puissance à semi-conducteur fournissant du courant à une charge, le dispositif recevant un signal d'entrée qui est destiné à piloter le commutateur de puissance à semi-conducteur, la méthode comportant les étapes de :
- détermination d'un premier et d'un deuxième seuils à partir d'une valeur d'une alimentation à laquelle le commutateur de puissance à semi-conducteur est connecté,
- détection de la tension drain-source du commutateur de puissance à semi-conducteur lorsque le commutateur de puissance à semi-conducteur passe de l'état de conduction à l'état de non conduction,
- comparaison, lors de la commutation du commutateur de puissance à semi-conducteur de l'état de conduction à l'état de non conduction, de la tension drain-source à la première valeur de seuil,
- combinaison du signal d'entrée avec une tension représentative de la dérivée de la tension drain-source si la tension drain-source est supérieure à la première valeur de seuil, et pilotage de la grille du commutateur de puissance à semi-conducteur afin de limiter la vitesse de variation de la tension drain-source,
- détection de la tension drain-source du commutateur de puissance à semi-conducteur lorsque le commutateur de puissance à semi-conducteur passe de l'état de non conduction à l'état de conduction,
- comparaison, lors de la commutation du commutateur de puissance à semi-conducteur de l'état de non conduction à l'état de conduction, de la tension drain-source à la deuxième valeur de seuil,
- combinaison du signal d'entrée avec une tension représentative de la dérivée de la tension drain-source si la tension drain-source est inférieure à la deuxième valeur de seuil et pilotage de la grille du commutateur de puissance à semi-conducteur afin de limiter la vitesse de variation de la tension drain-source.
